(19) Europäisches Patentamt

European Patent Office

Office européen des brevets

(11) Publication number: **0 155 138 B1**

# EUROPEAN PATENT SPECIFICATION

(45) Date of publication of patent specification: **10.07.91**　(51) Int. Cl.⁵: **G03B 41/00, G03F 1/00**

(21) Application number: **85301512.1**

(22) Date of filing: **05.03.85**

(54) **A reticle used in semiconductor device fabrication and a method for inspecting a reticle pattern thereon.**

(30) Priority: **05.03.84 JP 41584/84**

(43) Date of publication of application:
**18.09.85 Bulletin 85/38**

(45) Publication of the grant of the patent:
**10.07.91 Bulletin 91/28**

(84) Designated Contracting States:
**DE FR GB**

(56) References cited:
**EP-A- 0 066 466**

(73) Proprietor: **FUJITSU LIMITED**
**1015, Kamikodanaka Nakahara-ku**
**Kawasaki-shi Kanagawa 211(JP)**

(72) Inventor: **Shougo, Matsui c/o Fujitsu Limited**
**Patent Department 1015, Kamikodanaka**
**Nakahara-ku Kawasaki-shi Kanagawa,**
**211(JP)**

(74) Representative: **Sunderland, James Harry et al**
**HASELTINE LAKE & CO Hazlitt House 28**
**Southampton Buildings Chancery Lane**
**London WC2A 1AT(GB)**

## Description

The present invention relates to a reticle used in a patterning process for fabricating a semiconductor device as claimed in claim 1, a method for inspecting a reticle pattern on it as claimed in claim 4 and a method for applying a patterning process as claimed in claim 8.

Semiconductor devices are fabricated by a patterning process; a semiconductor die is fabricated by printing images of different patterns onto the same semiconductor substrate and its mass production is performed by printing simultaneously the same patterns arranged repeatedly. The reticle pattern is an original pattern in the patterning process.

Typically, a reticle substrate is made of a quartz glass plate on which the reticle pattern is formed by a coating of a metal such as nickel. Patterning of a semiconductor substrate may be achieved by exposing directly the image of the reticle pattern or by exposing the image of a photomask pattern, fabricated by printing the image of a reticle pattern, onto a photomask substrate made of a quartz glass plate.

Recently, integrated circuits (IC's) with very high packing density have been produced, and the reticle pattern for such IC's is very elaborate. For these IC's, the exposure of the reticle pattern on the semiconductor or photomask substrate is performed by the following steps: producing a reticle pattern of an enlarged size, as large as 5 to 10 times the size of the pattern size to be printed on the substrate; and exposing the image of the reticle pattern on the substrate by an optical system having a reduction power from 1/10 to 1/5.

The reticle pattern plays a significant part in IC fabrication, and consequently inspection of the reticle pattern is very important. The inspection of a reticle pattern may be made by any of the following three methods: firstly, a visual inspecting method performed by human observation of each reticle pattern with a microscope; secondly, a pattern comparing method performed by comparing electrical signals obtained by converting two optical images of reticle patterns from a pair of microscopes using an image sensor; and thirdly, a data comparing method performed by comparing two groups of data: one obtained from the reticle pattern using an image sensor and the other obtained from design data for the fabrication of the reticle pattern.

Visual inspection is rarely applied to processes for mass production of semiconductor devices, because many man-hours are required and a miss or error in inspection easily occurs. The pattern comparing method is effective for inspecting a reticle pattern having repeated patterns, such as memory patterns of a memory IC, because the speed of inspection is then high, but it is not effective for inspecting a reticle pattern not having repeated patterns, such as a pattern for a logic IC. The data comparing method is effective for inspecting a reticle pattern not having repeated patterns. Since the data comparing method provides high inspection accuracy, and the inspection speed has recently increased along with the rapid development of semiconductor devices (and hence of computing apparatus) the data comparing method has come to be applied to the inspection of almost all kinds of reticle patterns.

A reticle in accordance with the present invention is applicable to inspection by any of the above three methods, however the data comparing method will be discussed below.

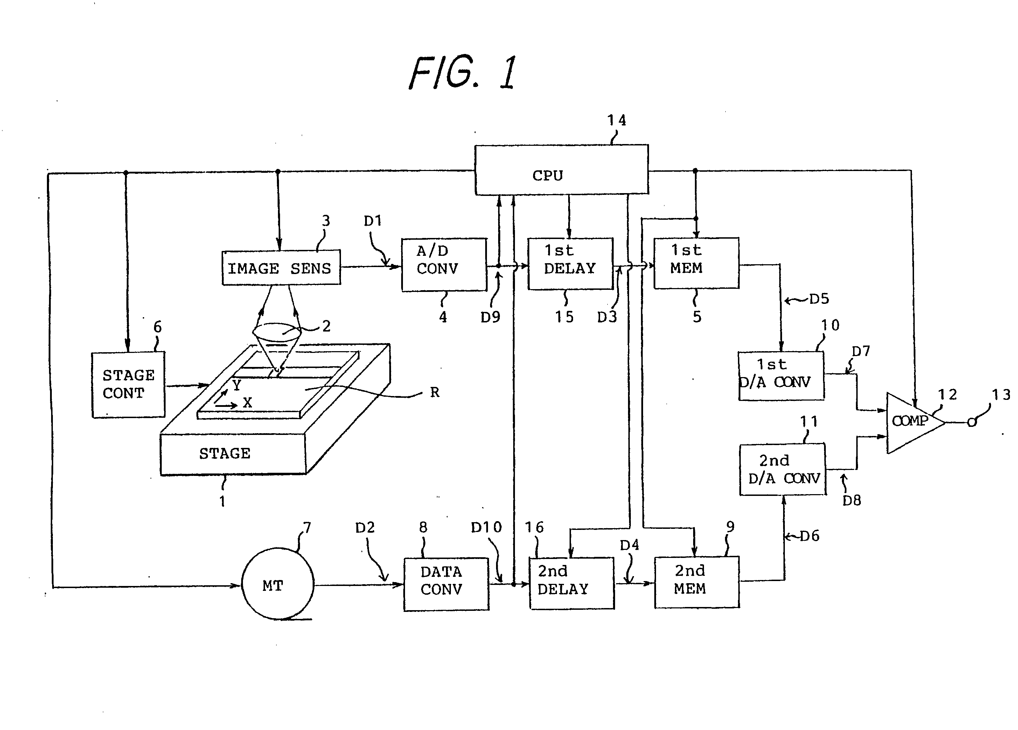

There now follows a brief explanation of an operational principle of a proposed mask inspecting apparatus. The data comparing method can be performed by a mask inspecting apparatus whose block diagram is shown in Fig. 1. In the Figure, a reticle pattern is coated on a reticle plate R which is installed on a stage (STAGE) 1. A central processing unit (CPU) 14 controls a stage controller (STAGE CONT) 6 so as to drive the STAGE 1 to shift a reticle plate R in X and Y directions against an optical system 2; usually, one of the directions (direction X, for example) is used for scanning and the other (direction Y) is used for shifting the scanning step by step. The optical system 2 is provided by taking the image of the reticle pattern to an image sensor (IMAGE SENS) 3. The IMAGE SENS 3 consists of sensing elements formed in a linear array being arranged perpendicularly to an optical axis of the optical system 2 and in a transverse direction to a scanning direction of the reticle plate R; for example, the array is arranged in the Y direction.

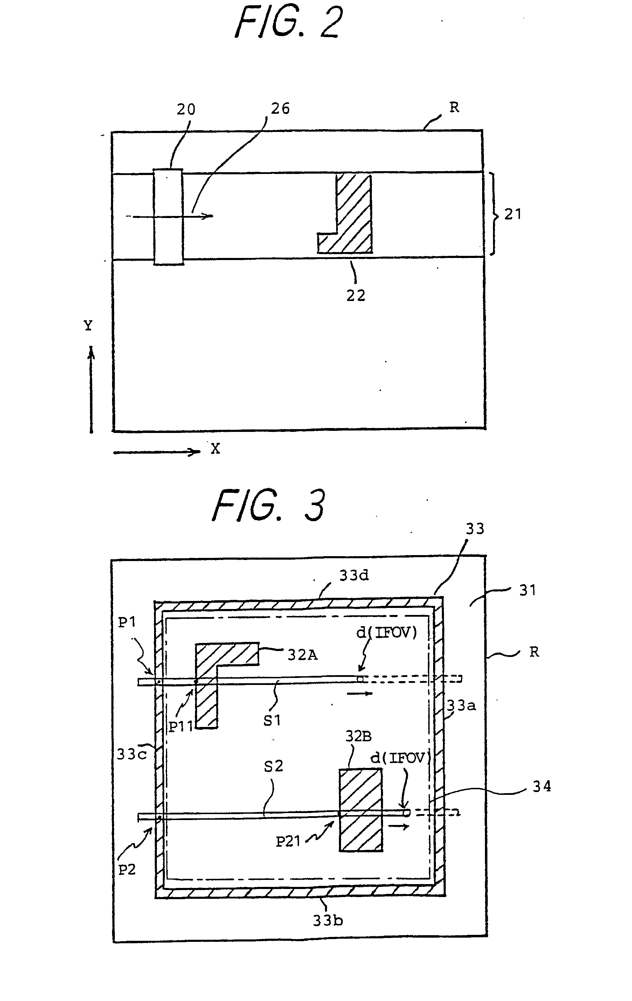

This is shown in Fig. 2, which is a plan view of the reticle plate R and illustrates the scanning of an instantaneous(ly) field of view (IFOV) of the IMAGE SENS 3. Reference numeral 20 shows the IFOV of the IMAGE SENS 3 consisting of 1024 linearly arrayed sensing elements. The IFOV 20 scans the surface of the reticle plate R in a direction 26 with a scanning width 21 when the plate R is moved in a minus X direction. The IFOV 20 scans the whole surface of the reticle plate R, for example by moving the plate R in minus and plus X directions alternately and in the plus Y direction step by step. Reference numeral 22 is a reticle pattern; when the IFOV 20 is scanned across the pattern 22, the IMAGE SENS 3 in Fig.1 produces an electric output D1 consisting of 1024 analog signals each having a high amplitude when the IFOV of a sensing element scans a part of the reticle pattern 22.

In Fig. 1, the signals D1 are fed to an analog-to-digital converter (A/D CONV) 4 in which the signals D1 are converted to digital signals D9 each in the form of a bit signal 1 or 0 corresponding to the amplitude of the input analog signal. The digital signals D9 are fed to a first delay circuit (1st DELAY) 15 in which the digital signals D9 are delayed. This delay is performed by a command from the CPU 14 to adjust a timing between the signals D9 which are intended to be written into a first memory (1st MEM) 5 and their address signals being provided in the CPU 14. This will be more precisely explained later. Delayed digital signals D3 from the 1st DELAY 15 are fed to the first memory (1st MEM) 5 and stored as detected pattern data.

On the other hand, the CPU 14 controls a magnetic tape device (MT) 7 so as to produce designed data signals of the reticle pattern synchronizing (synchronized) with the scanning of the IMAGE SENS 3 against the reticle plate R. Digital signals D2 from the MT 7 are fed into a data converter (DATA CONV) 8 in which the format of the signals D2 is converted to the same format as that of the signals D9; this is data format conversion. Converted signals D10 from the DATA CONV 8 are fed to a second delay circuit (2nd DELAY) 16 in which the signals D10 are delayed in a similar manner as mentioned above. Delayed digital signals D4 from the 2nd DELAY 16 are fed to a second memory (2nd MEM) 9 and stored as designed pattern data. The detected pattern data stored in the 1st MEM 5 and the designed pattern data stored in the 2nd MEM 9 are read out and fed to a first digital-to-analog converter (1st D/A CONV) 10 and a second digital-to-analog converter (2nd D/A CONV) 11 respectively by a command from the CPU 14. Read out digital signals D5 and D6 from the 1st MEM 5 and 2nd MEM 9 are converted into analog signals D7 and D8 respectively, and both analog signals are compared by a comparator (COMP) 12, so that a fault signal is obtained from an inspection output terminal 13 if there is a difference between them. A timing signal for the comparison is fed to the COMP 12 from the CPU 14.

In the above description, the process to provide the address signals in the CPU 14 for storing the delayed digital signals D3 and D4 into the 1st and 2nd memories 5 and 9 respectively is significant in comparing the detected pattern data with the designed pattern data. This is because the signals D3 and D4 must be stored into respective memory cells in respective 1st and 2nd memories 5 and 9 with their correct (corresponding) addresses, so that both data can be simply read out for the comparison as mentioned above.

As the reticle pattern is the inspected object, it is impossible to obtain address information from the reticle pattern itself by simple scanning. However, this has been solved by printing a reference pattern on the surface of the reticle plate with the reticle pattern, and also storing designed data of the reference pattern on the magnetic tape for use as standard data. That is, the signals detected from an actual reference pattern can be synchronized with the signals obtained from the designed reference pattern data, so address information of the inspected reticle pattern can be provided from the detected reference pattern signals having been synchronised with the designed reference signal.

A typical reference pattern of a proposed type is shown in Fig. 3. The Figure is a plan view of a surface 31 of a reticle plate R. On the surface 31, reticle patterns 32A, 32B are formed in an actual pattern-region 34 surrounded by a chain line which corresponds to an area of a single semiconductor die, and a reference pattern 33 is formed outside the actual pattern-region 34. That is, the reticle patterns 32A and 32B are surrounded by the reference pattern 33 having a shape of a frame consisting of four sides 33a, 33b, 33c, and 33d. The surface 31 is actually scanned by the IFOV of the linearly arrayed sensing elements as shown in Fig. 2, but a case of one element (of the) IFOV (d-(IFOV)) will be discussed hereinafter for simplicity.

When the d(IFOV) scans along a scanning line S1 as shown in Fig. 3, a detected signal of the reference pattern 33c is obtained at the point P1, which detected signal will be called a "detected reference signal" hereinafter. From the detected reference signal, the address signals along the scanning line S1 can be obtained as follows: in Figs. 1 and 2, the detected reference signal is fed to the 1st DELAY 15 and to the CPU 14 through the A/D CONV 4; at the same time, the MT 7 produces a signal of the designed reference pattern data corresponding to the point P1 under the control of the CPU 14, which signal will be called a "designed reference signal". The designed reference signal is fed to the 2nd DELAY 16 and to the CPU 14 through the DATA CONV 8; in the CPU 14, the detected reference signal is sychronised with the designed reference signal producing a synchronised detected reference signal. The address signals along the scanning line S1 from the point P1 are obtained from the synchronized detected reference signal using a clock signal provided in the CPU 14 and stored in a memory device in the CPU 14. The stored address signals are read out from the memory device and fed to the 1st MEM 5, and the delayed digital signals D3 obtained along the scanning line S1 are written into the 1st MEM 5 by the address signals under command from the CPU 14.

Address signals along another scanning line can be obtained in the same way the address signals are stored in the same memory device in the CPU 14, and the delayed digital signals D3

**EP 0 155 138 B1**

obtained along the scanning line are stored in the 1st MEM 5 by the address signals under a command from the CPU 14. Address signals of the designed data along a scanning line corresponding to the scanning line S1 can be also provided and are stored in another memory device in the CPU 14, however, synchronisation is not necessary because the designed reference signal itself is standard. The address signals are fed to the 2nd MEM 9 and the delayed digital signals D4 are stored into the 2nd MEM 9 by the address signals under a command from the CPU 14. The 1st DELAY 15 and 2nd DELAY 16 function so as to delay the digital signals D9 and D10 for adjusting a timing to provide their address signals in the CPU 14 for storing them into the 1st MEM 5 and 2nd MEM 9 respectively.

Any kind of shape can be used as a reference pattern in principle, and the type of reference pattern 33 shown in Fig.3 has been valued because synchronization by the reference pattern can be performed whatever direction on the reticle plate is taken as the scanning direction (X direction). However, recently, as the packing density of the reticle pattern has increased, the following problems have arisen with the reference pattern 33:

1) the quantity (capacity) of the memory devices required for the address signals in the CPU 14 has increased tremendously;

2) it is difficult to keep the inspection accuracy high because the interval between the reference patterns has become relatively long compared with (intervals between) reticle patterns having high packing density; and

3) false rejection of the inspection due to irregular scanning motion of the stage occurs: false rejection is a miss judgement of the inspection and occurs when the stage moves in irregular motion over the interval of the reference patterns. For example, comparing the scanning lines S1 and S2 in Fig. 3, the probability of irregular motion occurring in the interval between P1 and P11 on the scanning line S1 is less than that in the interval between P2 and P21 on the scanning line S2, because the former interval is shorter than the latter interval.

Furthermore, the orthogonality of the retical pattern is difficult to inspect using the reference pattern 33 because the reference patterns 33d and 33b in the Y direction are separated too far.

These problems could be solved if the reference patterns were distributed in the area (actual pattern region) of the reticle pattern. However, it has been considered that this is impossible to realise. This is because, if the reference patterns are in the area of the reticle pattern, since the reference pattern is designated as a constant pattern, the freedom of designing the reticle pattern will be reduced and a considerable amount of space for the reticle pattern will be lost.

An embodiment of the present invention can reduce the quantity of memory devices used in a CPU of an inspection apparatus for carrying out inspection of a reticle pattern by the data comparing method.

An embodiment of the present invention can maintain high accuracy in the inspection of a reticle pattern at low cost.

An embodiment of the present invention can avoid the occurrence of false rejection due to irregular scanning motion of a stage during reticle pattern inspection.

An embodiment of the present invention can enable inspection of orthogonality of a reticle pattern.

According to the present invention there is provided a reticle applied to a patterning process for fabricating a semiconductor device, comprising:

a reticle substrate;

a reticle pattern formed in an actual pattern-region on a surface of said reticle substrate; and

a reference pattern formed in said actual pattern-region on said surface with said reticle pattern, said reference pattern comprising elements of a size under a resolution limit of a reduction exposure performed in said patterning process.

An embodiment of the present invention can provide a reference pattern for inspecting a reticle pattern. The reference pattern consists of reference pattern pieces each having the same shape and size, printed on a surface of the reticle, being distributed extensively in the area of the reticle pattern. The size of each piece is so small that there is no influence on the patterning process, because the image size of the piece projected on a substrate for the semiconductor device or a photomask is less than a resolution limit of reducing exposure in the patterning process.

An embodiment of the present invention can provide a reticle for use in IC fabrication with a reference pattern obtained by dividing the reference pattern into a plurality of pieces or elements, and shortening the interval of the pieces and distributing the pieces extensively in the area of the reticle pattern. The size of each piece printed on the reticle plate is small, but large enough to be detected in a scanning operation for inspection of the reticle plate. However, the image of the piece on the semiconductor device or the photomask is so small that the image is not actually printed because its size is under the resolution limit of a reducing optical system used in a patterning process for the fabrication of the semiconductor device or the photomask.

Reference is made, by way of example, to the accompanying drawings in which:

Fig.1 is a block diagram of an apparatus for inspecting a reticle pattern;

Fig.2 illustrates scanning of linear arrayed image sensors of the inspecting apparatus over the surface of a reticle plate;

Fig.3 is a plan view of the surface of a reticle plate of which a reference pattern of a known type is printed with the reticle pattern;

Fig.4 is a plan view of the surface of a reticle plate on which a reference pattern in accordance with an embodiment of the present invention is printed with the reticle pattern;

Fig.5 illustrates the shape of a reference pattern piece in an embodiment of the present invention ; and

Fig.6 is a plan view of part of a reticle pattern surface on which a reference pattern in accordance with an embodiment of the present invention is printed with the reticle pattern, the plan view illustrating scanning over the reticle plate.

The present invention was made having regard to the following two factors relating to the patterning or printing process of a reticle pattern on a semiconductor device or photomask. Firstly, there may be a difference of size as much as from 5 to 10 times between the reticle pattern and its printed pattern on the semiconductor device or photomask. Secondly, an optical system for printing the image of the reticle pattern has characteristics of "resolution" which limit the smallest feature of a reticle pattern which can be printed on the semiconductor device or photomask. In accordance with the present invention the reference pattern is divided into a plurality of small pieces or elements each having the same size and shape, the size being determined so as to be large enough to be detected in the reticle pattern inspection but not large enough to be printed on the semiconductor device or photomask by a reduction exposure in the reticle patterning process. Therefore, the pieces or elements of the reference pattern in the present invention, which will be simply called "reference patterns" hereinafter, can be distributed in any place on the reticle plate, even in the reticle pattern, so that the reference patterns can be arranged more closely. The reference pattern can be marked on the reticle plate so as to be opaque, like pieces of the reticle pattern, in a space containing no reticle pattern, and transparent in a space containing a piece of the reticle pattern.

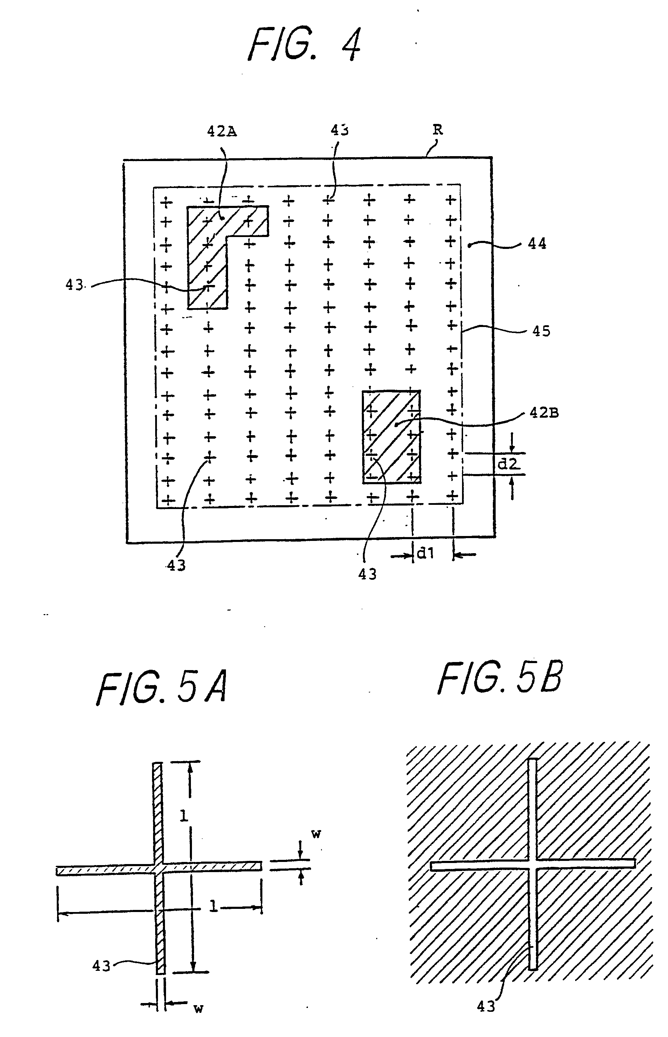

Fig.4 shows reference patterns in accordance with an embodiment of the present invention. In the Figure, a plurality of small pieces (cross shaped marks) are used as reference patterns 43 and are extensively distributed in the actual pattern-region 45 (surrounded by a chain line in the Figure), on the surface 44 of the reticle plate R. The reference patterns 43 are arranged regularly having pitches d1 and d2 in lateral and longitudinal directions respectively. Reference numerals 42A and 42B are reticle patterns in which the reference patterns are also printed. Each piece (element) of the reference patterns 43 has the same shape and size, and the size is small enough for the above conditions to be satisfied.

The reference pattern can take any shape in principle : Fig.5 shows a cross shaped pattern as an example. Fig.5A and 5B show an opaque and a transparent pattern respectively ; in the Figures, the cross hatched portions are optically opaque. The optically opaque pattern shown in Fig. 5A may be printed in regions of the reticle substrate where no reticle pattern exists. The optically transparent pattern shown in Fig.5B may be printed in regions of the reticle substrate containing reticle patterns. Thus, the reference pattern comprises an optically opaque pattern on said reticle substrate on which no reticle pattern exists, and an optically transparent pattern on said reticle pattern. The width (w) of each cross arm should be less than 1 micron if the reduction power of the reducing optical system for projecting the reticle pattern on the semiconductor or photomask substrate is 1/5, and less than 2 microns for the reduction power 1/10, and the length (1) of each cross arm can take any length but is, for example, 100 microns in Fig.5.

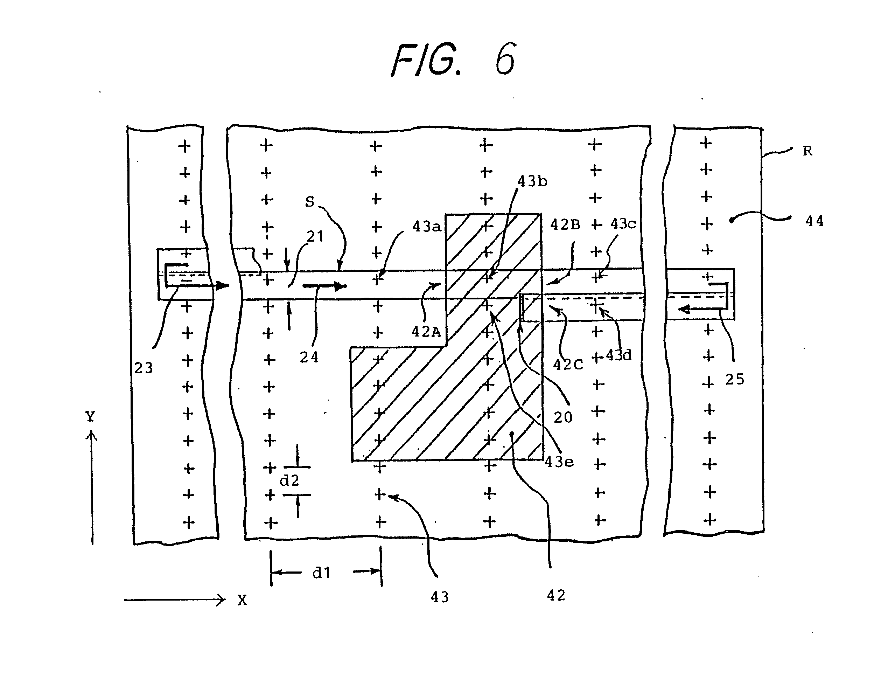

Fig.6 illustrates how the surface 44 of the reticle plate R may be scanned, showing a plate view of a part of the surface 44 of the reticle plate R on which reference patterns 43 and a reticle pattern 42 are printed. Reference symbol S shows a scanning line provided by running the IFOV 20 in the X direction writing a zigzag pattern from end to end of the surface 44 as shown by arrows 23,24, and 25, the IFOV 20 consisting of 1024 d(IFOV) for example. The reference patterns 43 are regularly distributed on the surface 44 having lateral and longitudinal pitches d1 and d2 respectively. A suitable relationship between the longitudinal pitch d2 and a width 21 of the scanning line S, is that the width 21 is a little larger than the pitch d2, for example the width 21 is 1.1 mm and the pitch is 1 mm, so that at least a d(IFOV) (i.e. at least one element) of the IFOV 20 scans a reference pattern 43.

When the d(IFOV) scans over a reference pattern 43a, the detected reference signal of the reference pattern 43a is synchronized in the CPU 14 with the designed reference signal of the designed reference pattern corresponding to the reference pattern 43a, and the synchronized detected reference signal of the pattern 43a designates the address signals for other detected signals in the area restricted (bounded) by the width 21 and two lines which transverse with the scanning line S involving respectively the reference patterns 43a and 43b. In the same way, all other address signals in the area of the scanning line S restricted by transverse lines involving reference patterns 43b and 43c and transversal lines involving reference patterns 43d and 43e are determined by synchronized detected reference signals of the reference pattern 43b and 43d respectively in the CPU 14. Therefore, addresses for all the signals detected from the reticle pattern 42 are designated, so that the detected signals are stored correctly in the 1st MEM 5, so that the reticle pattern 42 can be inspected by comparison with the designed reticle pattern data corresponding to the reticle pattern 42.

Comparing the reference patterns of the present invention with known reference patterns, it will be clear that:

the number of memory elements in the CPU 14 required for providing the address signals of the detected signals is reduced in accordance with the present invention, because the X direction interval of the reference patterns in the present invention is shorter;

the inspection accuracy with a reticle pattern having high packing density is higher in the present invention, because the resolution for detecting the reticle pattern in the present invention can be increased more than with known reference patterns in the limitation of the memory element numbers;

the probability (number) of occurrence of false rejection of the inspection due to irregular motion of the stage is reduced in the present invention, because the X direction interval of the reference patterns in the present invention is less than that of known reference patterns; and

inspection of the orthogonality of the reticle pattern can be more easily performed, because the Y direction interval of the reticle patterns in the present invention is less than that of known reference patterns.

Since the size of each reference pattern 43 is small as shown in Fig.5, the reference pattern does not appear on the reticle pattern printed on the semiconductor or the photomask substrate. For example, in Fig.5, as the width w of the reference pattern is 1 micron, the size of exposed image of the width w becomes theoretically 0.2 micron if the reduction power of the optical system is 1/5. However, this 0.2 micron is less than the resolution power of the reducing optical system; the resolution power is approximately 1 micron. This means that the width w of 1 micron actually has no influence on the pattern printed on the substrate. In other words, due to the limitations of resolution of the reducing optical system, the reference pattern is not actually printed onto the semiconductor or photomask substrate. The width w can be raised to 2 microns if the reduction power is 1/10.

As explained above, embodiments of the present invention can provide a reticle used in a patterning process for fabricating a semiconductor device or a photomask, having a reference pattern consisting of a plurality of reference pattern pieces or elements each having the same shape and size, the size being under a resolution limit of a reduction exposure performed in the patterning process. The reference pattern pieces are extensively printed in an actual pattern region for a semiconductor die on a reticle substrate with a reticle pattern so that the reference pattern pieces may be used for inspecting the reticle pattern but give no influence to a printed pattern of the reticle pattern on a substrate of the semiconductor device or the photomask. In inspection of the reticle pattern, detected reticle pattern data is obtained from the reticle pattern by scanning, for comparison with designed reticle pattern data. This comparison is enabled by synchronizing detected reference signals obtained from the reference pattern pieces by scanning, with reference signals obtained from design data of the reference pattern.

## Claims

1. A reticle applied to a patterning process for fabricating a semiconductor device, comprising:

   a reticle substrate;

   a reticle pattern formed in an actual pattern-region on a surface of said reticle substrate; and

   a reference pattern formed in said actual pattern-region on said surface with said reticle pattern, said reference pattern comprising elements of a size under a resolution limit of a reduction exposure performed in said patterning process.

2. A reticle according to claim 1, wherein said reticle substrate is optically transparent, said reticle pattern is optically opaque, and said reference pattern comprises an optically opaque element in a region of said reticle substrate where no reticle pattern exists and an optically transparent element in a region of said actual pattern-region where said reticle pattern exists.

3. A reticle according to claim 2, wherein said reference pattern comprises a plurality of reference pattern elements each having the same shape and size, said size being under a resolution limit of a reduction exposure performed in said patterning process, and said reference pattern elements being arranged on said surface with a constant first pitch in a first direction and with a constant second pitch in a

4. A method for inspecting a reticle pattern which is formed on a reticle substrate and applied to a patterning process for fabricating a semiconductor device, said method comprising the steps of:

forming said reticle pattern and a reference pattern in an actual pattern-region on a surface of said reticle substrate, said reference pattern having elements of a size under a resolution limit of a reduction exposure performed in said patterning process;

detecting said reticle pattern and said reference pattern respectively by scanning optically an instantaneous field of view of an image sensing device, producing detected reticle pattern signals and detected reference pattern signals respectively;

synchronizing individually said detected reference pattern signals with designed reference pattern signals obtained from designed reference pattern data; and

comparing said detected reticle pattern data with designed reticle pattern data.

5. A method according to claim 4, wherein

said reference pattern comprises a plurality of reference pattern elements each having a same shape and a same size which is under a resolution limit of a reduction exposure performed in said patterning process, and

said reference pattern elements being arranged on said surface with an equal first pitch in a first direction and with an equal second pitch in a second direction.

6. A method according to claim 5, wherein said image sensing device comprises a plurality of linearly arrayed sensing elements whose array direction is perpendicular to a direction of said scanning, and said second pitch is less than a length of an instantaneous field view of said linearly arrayed sensing elements.

7. A method according to claim 4, 5, or 6, wherein said reticle substrate is optically transparent, said reticle pattern is optically opaque, said reference pattern comprises an optically opaque pattern element in a region of said reticle substrate in which no reticle pattern exists and an optically transparent element on said reticle pattern.

8. A method applying a patterning process for fabricating a semiconductor device, said method comprising the steps of:

providing a reticle substrate;

forming a reticle pattern in an actual pattern-region on a surface of said reticle substrate;

forming a reference pattern in said actual pattern-region on said surface with said reticle pattern, said reference pattern comprising elements of a size under a resolution limit of a reduction exposure performed in said patterning process;

inspecting said reticle pattern formed on said surface by detecting reference signals from said reference pattern, and synchronizing said detected reference signals with designed reference signals obtained from designed reference pattern data; and

printing an image of said reticle pattern onto an exposed substrate by means of optical reduction exposure in said patterning process.

9. A method according to claim 8, wherein said exposed substrate comprises a semiconductor substrate.

10. A method according to claim 8, wherein said exposed substrate comprises a photomask substrate.

**Revendications**

1. Réticule appliquée à un processus de réalisation de motif pour la fabrication d'un dispositif à semiconducteur, comprenant :

un substrat de réticule ;

un dessin de réticule formé dans une région de dessin réel sur une surface dudit substrat de réticule ; et

un dessin de référence formé dans ladite région de dessin réel sur ladite surface avec ledit dessin de réticule, ledit dessin de référence comprenant des éléments ayant une taille inférieure à une limite de résolution d'une exposition en réduction effectuée pour le processus de réalisation de motif.

2. Réticule selon la revendication 1, dans laquelle ledit substrat de réticule est optiquement transparent, ledit dessin de réticule est optiquement opaque, et ledit dessin de référence comprend un élément optiquement opaque dans une région dudit substrat de réticule dans laquelle il n'existe aucun dessin de réticule et un élément optiquement transparent dans une région de ladite région de dessin réel dans laquelle il existe un dessin de réticule.

3. Réticule selon la revendication 2, dans laquelle ledit dessin de référence comprend une pluralité d'éléments de dessin de référence dont chacun a la même forme et la même taille, ladite taille étant inférieure à une limite de résolution d'une exposition en réduction effectuée pour ledit processus de réalisation de motif, et lesdits éléments de dessin de référence étant disposés sur ladite surface de façon à avoir un premier pas constant dans une première direction et un second pas constant dans une seconde direction.

4. Procédé d'inspection d'un dessin de réticule qui est formé sur un substrat de réticule et qui est appliqué à un processus de réalisation de motif pour la fabrication d'un dispositif à semiconducteur, ledit procédé comprenant les étapes de :

formation dudit dessin de réticule et d'un dessin de référence dans une région de dessin réel sur une surface dudit substrat de réticule, ledit dessin de référence comprenant des éléments ayant une taille inférieure à une limite de résolution d'une exposition en réduction effectuée pour ledit processus de réalisation de motif ;

détection respectivement dudit dessin de réticule et dudit dessin de référence en balayant optiquement un champ de vision instantané d'un dispositif détecteur d'image, en produisant respectivement des signaux de dessin de réticule détecté et des signaux de dessin de référence détecté ;

synchronisation de façon individuelle desdits signaux de dessin de référence détecté avec des signaux de dessin de référence conçu provenant de données de dessin de référence conçu ; et

comparaison desdites données de dessin de réticule détecté avec lesdites données de dessin de réticule conçu.

5. Procédé selon la revendication 4, dans lequel ledit dessin de référence comprend une pluralité d'éléments de dessin de référence dont chacun a la même forme et la même taille qui est inférieure à une limite de résolution d'une exposition en réduction effectuée pour ledit processus de réalisation de motif, et

lesdits éléments de dessin de référence sont arrangés sur ladite surface de façon à présenter un premier pas constant dans une première direction et un second pas constant dans une seconde direction.

6. Procédé selon la revendication 5, dans lequel ledit dispositif détecteur d'image comprend une pluralité d'éléments de détection disposés en réseau de façon linéaire dont une direction du réseau est perpendiculaire à une direction du balayage, et dans lequel ledit second pas est inférieur à une longueur d'un champ de vision instantané desdits éléments de détecteur disposés en réseau de façon linéaire.

7. Procédé selon les revendications 4, 5 ou 6, dans lequel ledit substrat de réticule est optiquement transparent, ledit dessin de réticule est optiquement opaque, ledit dessin de référence comprend un élément de dessin optiquement opaque dans une région dudit substrat de réticule dans laquelle il n'existe aucun dessin de réticule et un élément optiquement transparent sur ledit dessin de réticule.

8. Procédé d'application d'un processus de réalisation de motif pour la fabrication d'un dispositif à semiconducteur, ledit procédé comprenant les étapes de :

fourniture d'un substrat de réticule ;

formation d'un dessin de réticule dans une région de dessin réel sur une surface dudit substrat de réticule ;

formation d'un dessin de référence dans ladite région de dessin réel sur ladite surface qui comprend ledit dessin de réticule, ledit dessin de référence comprenant des éléments ayant une taille inférieure à une limite de résolution d'une exposition en réduction effectuée pour ledit processus de réalisation de motif ;

inspection dudit dessin de réticule formé sur ladite surface en détectant des signaux de référence à partir dudit dessin de référence, et en synchronisant lesdits signaux de référence détectés avec des signaux de référence conçus obtenus à partir de données de dessin de référence conçu ; et

impression d'une image dudit dessin de réticule sur un substrat exposé au moyen d'une exposition optique en réduction pour ledit processus de réalisation de motif.

9. Procédé selon la revendication 8, dans lequel ledit substrat exposé comprend un substrat semiconducteur.

10. Procédé selon la revendication 8, dans lequel ledit substrat exposé comprend un substrat de masque optique.

## Ansprüche

1. Marke, die bei einem Musterungsprozeß für die Herstellung einer Halbleitervorrichtung verwendet wird, mit:

einem Markensubstrat;

einem Markenmuster, das in einem tatsächlichen Musterbereich auf einer Oberfläche des genannten Markensubstrats gebildet wird; und

einem Referenzmuster, das in dem genannten tatsächlichen Musterbereich mit den genannten Markenmustern gebildet wird, welches Referenzmuster Elemente von einer Größe unter eine Auflösungsgrenze einer reduzierten Belichtung umfaßt, die bei dem genannten Musterungsprozeß durchgeführt wird.

2. Marke nach Anspruch 1, bei der das genannte Markensubstrat optisch transparent ist, das genannte Markenmuster optisch undurchlässig ist und das genannte Referenzmuster ein optisch undurchlässiges Element in einem Bereich des genannten Markensubstrats umfaßt, wo kein Markenmuster existiert, und ein optisch transparentes Element in einem Bereich des tatsächlichen Musterbereichs, wo das genannte Markenmuster existiert.

3. Marke nach Anspruch 2, bei der das genannte Referenzmuster eine Vielzahl von Referenzmusterelementen umfaßt, die jeweils dieselbe Form und Größe haben, und die genannte Größe unter einer Auflösungsgrenze einer Reduktionsbelichtung liegt, die bei dem genannten Musterungsprozeß durchgeführt wird, und die genannten Referenzmusterelemente auf der genannten Oberfläche mit einem konstanten ersten Rasterabstand in einer ersten Richtung und mit einem konstanten zweiten Rasterabstand in einer zweiten Richtung angeordnet sind.

4. Verfahren zum Inspizieren eines Markenmusters, welches auf einem Markensubstrat gebildet ist und bei einem Musterungsverfahren zur Herstellung einer Halbleitervorrichtung verwendet wird, welches Verfahren die folgenden Schritte umfaßt:

Bilden des genannten Markenmusters und eines Referenzmusters in einem tatsächlichen Musterbereich auf einer Oberfläche des genannten Markensubstrats, welches genannte Referenzmuster Elemente von einer Größe unter einer Auflösungsgrenze einer Reduktionsbelichtung hat, die bei dem genannten Musterungsprozeß durchgeführt wird;

Detektieren des genannten Markenmusters, bzw. des genannten Referenzmusters durch optisches Abtasten eines momentanen Gesichtsfeldes einer Bildfühlvorrichtung, welche detektierte Markenmustersignale bzw. Referenzmustersignale erzeugt;

individuelles Synchronisieren der genannten detektierten Referenzmustersignale mit designierten Referenzmustersignalen, die von designierten Referenzmusterdaten erhalten werden; und

Vergleichen der genannten detektierten Markenmusterdaten mit designierten Markenmusterdaten.

5. Verfahren nach Anspruch 4, bei dem das genannte Referenzmuster eine Vielzahl von Referenzmusterelementen umfaßt, die jeweils eine gleiche Form und gleiche Größe haben, die unter einer Auflösungsgröße einer Reduktionsbelichtung liegt, die bei dem genannten Musterungsverfahren durchgeführt wird, und die genannten Referenzmusterelemente auf der genannten Oberfläche mit einem gleichen ersten Rasterabstand in einer ersten Richtung und einem gleichen zweiten Rasterabstand in einer zweiten Richtung angeordnet sind.

6. Verfahren nach Anspruch 5, bei dem die genannte Bildfühleinrichtung eine Vielzahl von linear angeordneten Fühlelementen umfaßt, deren Anordnungsrichtung senkrecht zu einer Richtung der genannten Abtastung ist, und der genannte zweite Rasterabstand kleiner als eine Länge eines augenblicklichen Gesichtsfeldes der genannten linear angeordneten Fühlelemente ist.

7. Verfahren nach Anspruch 4, 5 oder 6, bei dem das genannte Markensubstrat optisch transparent ist, das genannte Markenmuster optisch undurchlässig ist, das genannte Referenzmuster ein optisch undurchlässiges Musterelement in einem Bereich des genannten Markensubstrats, in dem kein Markenmuster existiert, und ein optisch transparentes Element auf dem genannten Markenmuster umfaßt.

8. Verfahren des Anwendens eines Musterungsverfahrens zur Herstellung einer Halbleitervorrichtung, welches Verfahren die folgenden Schritte umfaßt:

Vorsehen eines Markensubstrats;

Bilden eines Markenmusters in einem tatsächlichen Musterbereich auf einer Oberfläche des genannten Markensubstrats;

Bilden eines Referenzmusters in dem genannten tatsächlichen Bereich auf der genannten Oberfläche des genannten Markenmusters, welches Referenzmuster Elemente von einer Größe unterhalb einer Auflösungsgrenze einer Reduktionsbelichtung umfaßt, die bei dem genannten Musterungsverfahren durchgeführt wird;

Inspizieren des genannten Markenmusters, das auf der genannten Oberfläche gebildet ist, durch Detektieren von Referenzsignalen von den genannten Referenzmustern, und Synchronisieren der genannten detektierten Referenzsignale mit designierten Referenzsignalen, die von den designierten Referenzmusterdaten erhalten werden; und

Drucken eines Bildes des genannten Markenmusters auf ein exponiertes Substrat mittels einer optischen Reduktionsbelichtung bei dem genannten Musterungsverfahren.

9. Verfahren nach Anspruch 8, bei dem das genannte exponierte Substrat ein Halbleitersubstrat umfaßt.

10. Verfahren nach Anspruch 8, bei dem das genannte exponierte Substrat ein Photomaskensubstrat umfaßt.

FIG. 1

EP 0 155 138 B1

# FIG. 2

# FIG. 3

# FIG. 4

# FIG. 5A

# FIG. 5B

FIG. 6